# EUROPEAN PATENT SPECIFICATION

(11) **EP 0 284 354 B1**
(45) Date of publication and mention of the grant of the patent: **12.06.1996**
(21) Application number: 88302512.4
(22) Date of filing: 22.03.1988
(51) Int. Cl.: H01L 39/24

(54) **Method of manufacturing superconducting ceramics**
Verfahren zur Herstellung von supraleitenden Keramiken
Procédé pour la fabrication de céramiques supraconductrices

(30) Priority: 23.03.1987 JP 69447/87; 27.03.1987 JP 75205/87
(43) Date of publication of application: 28.09.1988
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo 157 (JP)
(74) Representative: Milhench, Howard Leslie

(56) References cited:
- PATENT ABSTRACTS OF JAPAN, vol. 7, no. 122(C-168)(1267), 26 May 1983; & JP-A-58 41 795
- ZEITSCHRIFT FUER PHYSIK B - CONDENSED MATTER, vol. 64, pages 189-194, Springer-Verlag 1986; J.G. BEDNORZ et al.: "Possible High Tc Superconductivity in the Ba-La-Cu-O System"
- PATENT ABSTRACTS OF JAPAN, vol.8, no. 62 (C-215)(1499), 17 December 1983; & JP-A-58 217 493
- PATENT ABSTRACTS OF JAPAN, vol. 10, no. 90 (C-337)(2147), 8 April 1986; & JP-A-60 221 392
- Science, Vol. 235, pp. 567-569, 30 January 1987
- Japanese Journal of Applied Physics, Vol. 27, No. 2, February 1988, pp. L209-L210
- Nature, Vol. 349, 28 February 1991, pp. 770-772
- Proceedings of the conference on HTS materials, 1992 TCSUH Workshop, D. Bourgault et al.

## Description

### BACKGROUND OF THE INVENTION

This invention relates generally to the field of superconducting ceramics and particularly to manufacturing methods for making superconducting ceramics.

It has long been known that metals such as mercury and lead, intermetallics such as NbNd, Nb₃Ge and NbGa and ternary materials such as Nb₃(Al_{0.8}Ge_{0.2}) demonstrate superconductivity. However, the transition temperature of such long known conventional superconducting materials cannot exceed 25K.

In more recent years, superconducting ceramics have attracted widespread interest. A new material was first reported by researchers at the Zurich laboratory of IBM Corp. as Ba-La-Cu-O type high temperature superconducting oxides. Subsequently, La-Sr-Cu(II)-O-type superconducting oxides were also proposed. Another type of superconducting material that has been found is (YBa₂)Cu₃O₆₋₈. By virtue of the fact that these superconducting ceramics form a quasi-molecular atomic unit in a crystalline structure whose unit cell is constructed with one layer in which electrons have essentially one-dimensional motion, whereas only three dimensional electron conduction occurs in the long known materials mentioned above, higher transition temperatures are achieved.

Much work has been undertaken by researchers in the field who have endeavoured to elevate Tco, the temperature at which resistance vanishes, above the levels previously obtained and preferably above the boiling point of nitrogen (77K) or even higher. As described in our European Patent Application No. 87309081.5, we have investigated superconducting ceramic materials having the stoichiometric formulae (A₁₋ₓBₓ)_{y}Cu_{z}O_{w}, where A represents one or more rare earth elements, and B represents one or more elements of Group IIa of the Japanese Periodic Table, e.g. the alkaline earth elements including beryllium and magnesium, and in the continuation of these investigations we have disclosed that the existence of voids and grain boundaries in superconducting ceramic materials makes it difficult to obtain an elevated Tco.

### SUMMARY OF THE INVENTION

According to the present invention there is provided a method of manufacturing superconducting ceramics having a higher transition temperature than hitherto obtained and substantially devoid of imperfections, said method being characterized in that, for enhancing the superconducting properties of the material, the material is subjected to the application of a magnetic field during at least part of its formation, the strength of the magnetic field being selected to be not less than 0.05T(500 Gauss).

It will be seen from consideration of the following description of exemplary manufacturing techniques embodying the present invention that, whereas in previous attempts to find higher Tc superconducting materials attention has been focused upon the composition or molar ratios of the constituent elements, in accordance with the present invention improvements can be obtained by manufacturing superconducting ceramics from their raw constituents, that is to say the chemical compounds which are mixed together and fired to form the superconducting ceramic, under the influence of a magnetic field.

The magnetic field is preferably applied in the direction along which carriers can move easily, i.e. normal to the (a,b) plane, and the strength of the applied magnetic field is preferably between 0.05T(500 Gauss) and 10T(100,000 Gauss). Preferably the magnetic field is applied during a heating step in the formation of the superconducting ceramic material. By virtue of the application of the magnetic field, the ceramic mixture can be given a special orientation in which the atomic arrangement is ordered and made more simple, e.g. on the (a,b) plane, so that few grain boundaries and imperfections exist in the final ceramic material. As a result, a higher transition temperature can be obtained, and correspondingly the superconducting ceramic can be endowed with a higher critical current. For example, the Tc onset can be elevated to 50-107K and the critical current can be elevated to 10⁵ to 10⁶ A/cm², much higher than the critical current of the order of 10² A/cm² previously obtained in the prior art.

Other features of the invention are set forth with particularity in the appended claims and will become clear to those possessed of the relevant skills from consideration of the following description of illustrative examples.

### DETAILED DESCRIPTION OF THE EXAMPLES

Described hereinafter are a couple of examples illustrating the manufacture by a method according to the present invention of complex copper oxide superconducting ceramics conforming to the stoichiometric formulae (A₁₋ₓBₓ)_{y}Cu₂O_{w}, where A is one or more elements of Group IIIa of the Japanese Periodic Table as described in the Iwanami "Physics and Chemistry Dictionary" , e.g. the rare earth elements, B is one or more elements of Group IIa of the Japanese Periodic Table, e.g. the alkaline earth metals including beryllium and magnesium, and 0<x<1; y=2.0-4.0, preferably 2.5-3.5; z=1.0-4.0, preferably 1.5-3.5; and w=4.0-10.0, preferably 6.0-8.0. For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

### Example 1

Prescribed amounts of BaCo₃, CuO and Y₂O₃ (High Purity Chemical Industries Co.Ltd. 99.95% or higher) were used for preparing a superconducting ceramic material of the above formula where x=0.67, y=3, z=3 and w=6-9, i.e., in consistence with (YBa₂)Cu₃O₆₋₉. The factor "w" was controlled by adjusting the sintering conditions during formation of the ceramic material.

After being mixed in a ball mill, the high purity chemicals were pressed in a capsule at 30Kg/cm² and formed into a cylindrical shaped tablet of 5 mm diameter and 15 mm height. The tablet was heated (fired) and oxidized at 500-1200°C, e.g., 700°C, for 8 hours in an oxidizing atmosphere such as in air, this step being called pre-firing hereinafter.

The tablet was subjected to an applied magnetic field during the pre-firing. The magnetic field was produced by an electromagnet whose North pole was positioned proximately to one end of the tablet and whose South pole was positioned proximately to the opposite end of the tablet so as to subject the cylindrical tablet to a magnetic field in its axial direction. The strength of the applied magnetic field was 500 Gauss. The application of a stronger magnetic field is preferred if available.

Next, the tablet was finely ground in a ball mill to an average grain diameter of 200-0.03 microns, e.g., 10 microns or smaller. Then, the powder was pressed in a capsule at 50Kg/cm² to form a cylindrical tablet again.

The tablets were then fired, hereinafter called main-firing, for 10-50 hours at 500-1200°C, for example 15 hours at 900°C, in an oxidizing atmosphere such as air. Then, the tablets were heated and reduced in an O₂ atmosphere with 5-20 atom % Ar at 600-1200°C for 3-30 hours, for example at 800°C for 20 hours. The tablets were subjected to a magnetic field during the main-firing and reduction operations in the same manner as during the pre-firing operations.

The relationship between the temperature and the resistance was investigated for the thus-produced tablets, and as a result the highest Tc onset temperature and Tco were measured to be 101K and 94K respectively. The critical current densities obtained were larger than 3 × 10⁵ A/cm².

For comparison, the above described manufacturing process was repeated making no use of a magnetic field and, as a result, the Tc onset was 93K and the Tco was 73K.

### Example 2:

The procedure of Example 1 was repeated but with 50% of Y substituted by Yb and with the magnetic field alternating at a frequency of 50Hz. The Yb was introduced as an oxide. As a result, the Tc onset was measured to be 109K and Tco was 93K.

For comparison, this manufacturing process was repeated making no use of a magnetic field and, as a result, the Tc onset was 94K and the Tc was 81K. Accordingly, Tc onset and Tco were elevated by 15K and 12K respectively by application of the magnetic field.

The foregoing Examples are merely illustrative of the invention, and do not include all of the combinations of elements and process variations which may be used to produce superconducting ceramic materials in accordance with the invention, other combinations also being effective to provide improved superconducting materials. For example, superconducting ceramics also may be prepared in accordance with the invention which conform to the stoichiometric formulae (A₁₋ₓBₓ)_{y}Cu_{z}O_{w}, where A is one or more elements of Group Vb of the Japanese Periodic Table such as Bi, Sb and As, B is one or more elements of Group IIa of the Japanese Periodic Table, e.g., the alkaline earth metals including beryllium and magnesium, and 0.3≤ x <1; y=2.0-4.0, preferably 2.5-3.5; z=1.0-4.0, preferably 1.5-3.5; and w=4.0-10.0, preferably 6.0-8.0, e.g. (YBa₂)Cu₃O₆₋₈ or BiCaSrCu₃O₆₋₈.

While several examples have been specifically described, it is to be appreciated that the present invention is not limited to the particular examples described and that modifications and variations can be made without departure from the scope of the invention as defined by the appended claims. For example, the tablet may be pressed in a die at 50Kg/cm² for example during the main-firing; the constituent atoms are movable more easily at a higher temperature, so that the tablet becomes more dense by application of pressure during firing. Furthermore, whereas as described herein superconducting ceramics are prepared in the form of tablets, it is possible, after pre-firing or main-firing, to grind the tablets into a powder and to disperse the ground material into a liquid carrier whereby the resulting suspension may be applied to the surface of an object such as a substrate to form a thin film thereon. After being dried, the surface film can be fired with the application of a magnetic field in an oxidizing atmosphere to provide a superconducting thin film. Furthermore, it is also effective to apply a magnetic field to a thin superconducting film formed by sputtering or spraying. Still further, superconducting films can be formed by an ion plating or plasma melting spray method, in which a magnetic field is applied during film formation. Regardless of how the material is formed, the well-ordered structure obtained by the method of the invention is enhanced if the material being formed is heated, e.g. at 100-900°C.

## Claims

1. A method of manufacturing a superconducting ceramics material, said method being characterized in that, for enhancing the superconducting properties of the material, the material is subjected to the application of a magnetic field during at least part of its formation, the strength of the magnetic field being selected to be not less than 0.05T(500 Gauss).

2. The method of claim 1 wherein the magnetic field is applied during a heating step in the formation of the superconducting material.

3. The method of claim 1 or 2 wherein the superconducting ceramics material is formed by mixing together powdered chemical constituents of the desired superconducting ceramic material, consolidating the mixture, and firing the mixture to form the superconducting material, the magnetic field being applied to the consolidated mixture during the firing thereof.

4. The method of claim 3 wherein the formation of the superconducting ceramics material includes prefiring of said consolidated mixture and grinding of the prefired mixture into a fine powder prior to the consolidating of the fine powder and final firing of the same.

5. The method of claim 4 wherein a magnetic field is applied during both the prefiring and the final firing.

6. The method of claim 4 or 5 wherein the superconducting ceramics material is an oxide ceramics material and the prefiring is effected in an oxidizing atmosphere.

7. The method of claim 4 or 5 or 6 wherein the average grain diameter of the ground mixture is from 0.03 to 200 microns.

8. The method of any of claims 3 to 7 wherein firing is effected at from 500°C to 1200°C.

9. The method of any preceding claim wherein the strength of the magnetic field is selected to be from 0.05T(500 Gauss) to 10T(100,000 Gauss).

10. The method of any of claims 3 to 9 wherein the powder is subjected to compression during its firing under the application of the magnetic field.

11. The method of any of the preceding claims wherein the superconducting ceramics material is formed as a thin film by forming a fluid mixture of powdered chemical constituents of the desired superconducting ceramics material, applying the fluid mixture to a surface as a thin film, and firing the mixture on the surface, the magnetic field being applied to the thin film during the firing thereof.

12. The method of any of the preceding claims wherein the magnetic field is applied in the same direction as that in which the superconducting material is required to pass electric current.

13. The method of claim 12 wherein the sense of the applied magnetic field is constant.

14. The method of claim 12 wherein the sense of the applied magnetic field is alternating.

15. The method of any of the preceding claims wherein the superconducting ceramics material is a complex oxide material comprising copper.

16. The method of claim 15 wherein said complex oxide material is prepared in accordance with the stoichiometric formulae (A₁₋ₓBₓ)_{y}Cu_{z}O_{w}, where A is one or more elements from Group IIIa of the Japanese Periodic Table, B is one or more elements of Group IIa of the Japanese Periodic Table, and O<x<1, y=2-4, z=1-4 and w=4-10.

## Patentansprüche

1. Verfahren zum Herstellen eines supraleitenden Keramikmaterials, dadurch gekennzeichnet, daß das Material zur Verbesserung seiner Supraleitungseigenschaften wenigstens während eines Teils seiner Bildung einem Magnetfeld ausgesetzt wird, dessen Stärke nicht unter 0,05 T (500 Gauss) gewählt wird.

2. Verfahren nach Anspruch 1, wobei das Magnetfeld während eines Erwärmungsschritts beim Bilden des supraleitenden Materials angelegt wird.

3. Verfahren nach Anspruch 1 oder 2, wobei das supraleitende Keramikmaterial durch Zusammenmischen pulverförmiger chemischer Bestandteile des gewünschten supraleitenden Keramikmaterials, Verfestigen und Brennen des Gemisches gebildet wird, wobei das Magnetfeld während des Brennens des verfestigten Gemisches an diese angelegt wird.

4. Verfahren nach Anspruch 3, wobei zur Bildung des supraleitenden Keramikmaterials das Vorbrennen des verfestigten Gemisches und das Mahlen des vorgebrannten Gemisches zu einem feinen Pulver gehören, woraufhin das feine Pulver verfestigt und abschließend gebrannt wird.

5. Verfahren nach Anspruch 4, wobei während des Vorbrennens und des abschließenden Brennens ein Magnetfeld angelegt wird.

6. Verfahren nach Anspruch 4 oder 5, wobei das supraleitende Keramikmaterial ein Oxidkeramikmaterial ist und das Vorbrennen in einer oxidierenden Atmosphäre durchgeführt wird.

7. Verfahren nach Anspruch 4, 5 oder 6, wobei der mittlere Korndurchmesser des gemahlenen Gemisches zwischen 0,03 und 200 µm liegt.

8. Verfahren nach einem der Ansprüche 3 bis 7, wobei das Brennen bei 500°C bis 1200°C durchgeführt wird.

9. Verfahren nach einem der vorhergehenden Ansprüche, wobei die Magnetfeldstärke zwischen 0,05 T (500 Gauss) und 10 T (10⁵ Gauss) gewählt wird.

10. Verfahren nach einem der Ansprüche 3 bis 9, wobei das Pulver während des Brennens unter Anlegen des Magnetfeldes einem Druck ausgesetzt wird.

11. Verfahren nach einem der vorhergehenden Ansprüche, wobei das supraleitende Keramikmaterial als Dünnschicht ausgebildet wird, indem ein fließfähiges Gemisch aus pulverförmigen chemischen Bestandteilen des gewünschten supraleitenden Keramikmaterials gebildet, als Dünnschicht auf eine Oberfläche aufgebracht und dort gebrannt wird, wobei das Magnetfeld während des Brennens der Dünnschicht angelegt wird.

12. Verfahren nach einem der vorhergehenden Ansprüche, wobei das Magnetfeld in derselben Richtung angelegt wird, in der das supraleitende Material elektrischen Strom durchlassen soll.

13. Verfahren nach Anspruch 12, wobei die Richtung des angelegten Magnetfeldes konstant ist.

14. Verfahren nach Anspruch 12, wobei die Richtung des angelegten Magnetfeldes alterniert.

15. Verfahren nach einem der vorhergehenden Ansprüche, wobei das supraleitende Keramikmaterial ein kupferhaltiges komplexes Oxidmaterial ist.

16. Verfahren nach Anspruch 15, wobei das komplexe Oxidmaterial gemäß der stöchiometrischen Formel (A₁₋ₓBₓ)_{y}Cu_{z}O_{w} hergestellt wird, wobei A ein oder mehrere Elemente der Gruppe IIIa des japanischen Periodensystems bezeichnet, B ein oder mehrere Elemente der Gruppe IIa des japanischen Periodensystems bezeichnet und 0 < x < 1, y = 2 bis 4, z = 1 bis 4 und w = 4 bis 10.

## Revendications

1. Procédé pour fabriquer un matériau céramique supraconducteur, ledit procédé étant caractérisé en ce que, pour améliorer les propriétés de supraconductivité du matériau, un champ magnétique est appliqué au matériau pendant au moins une partie de sa formation, la force du champ magnétique étant choisie de façon à ne pas être inférieure à 0,05 T (500 Gauss).

2. Procédé selon la revendication 1, dans lequel le champ magnétique est appliqué au cours d'une étape de chauffage lors de la formation du matériau supraconducteur.

3. Procédé selon la revendication 1 ou 2, dans lequel le matériau céramique supraconducteur est formé par mélange des constituants chimiques en poudre du matériau céramique supraconducteur souhaité, compactage du mélange et calcination du mélange pour former le matériau supraconducteur, le champ magnétique étant appliqué au mélange compacté au cours de l'étape de calcination de celui-ci.

4. Procédé selon la revendication 3, dans lequel la formation du matériau céramique supraconducteur comprend la pré-calcination dudit mélange compacté et le broyage du mélange pré-calciné en une poudre fine avant le compactage de la poudre fine et la calcination finale de celle-ci.

5. Procédé selon la revendication 4, dans lequel un champ magnétique est appliqué à la fois pendant la pré-calcination et pendant la calcination finale.

6. Procédé selon la revendication 4 ou 5, dans lequel le matériau céramique supraconducteur est un matériau céramique de type oxyde et la pré-calcination est effectuée dans une atmosphère oxydante.

7. Procédé selon la revendication 4, 5 ou 6, dans lequel le diamètre moyen des grains du mélange broyé est de 0,03 à 200 µm.

8. Procédé selon l'une quelconque des revendications 3 à 7, dans lequel la calcination est effectuée à 500 - 1200°C.

9. Procédé selon l'une quelconque des revendications précédentes, dans lequel la force du champ magnétique est choisie de façon à être de 0,05 T (500 Gauss) à 10 T (100.000 Gauss).

10. Procédé selon l'une quelconque des revendications 3 à 9, dans lequel la poudre est soumise à une compression au cours de sa calcination sous l'application du champ magnétique.

11. Procédé selon l'une quelconque des revendications précédentes, dans lequel le matériau céramique supraconducteur est formé en un film mince par formation d'un mélange fluide des constituants chimiques en poudre du matériau céramique supraconducteur souhaité, application du mélange fluide sur une surface sous la forme d'un film mince, et calcination du mélange sur la surface, le champ magnétique étant appliqué au film mince au cours de la calcination de celui-ci.

12. Procédé selon l'une quelconque des revendications précédentes, dans lequel le champ magnétique est appliqué dans la même direction que celle dans laquelle le matériau supraconducteur doit faire passer le courant électrique.

13. Procédé selon la revendication 12, dans lequel le sens du champ magnétique appliqué est constant.

14. Procédé selon la revendication 12, dans lequel le sens du champ magnétique appliqué est alternatif.

15. Procédé selon l'une quelconque des revendications précédentes, dans lequel le matériau céramique supraconducteur est un matériau en oxyde complexe comprenant du cuivre.

16. Procédé selon la revendication 15, dans lequel ledit matériau en oxyde complexe est préparé conformément à la formule stoechiométrique (A₁₋ₓBₓ)Cu_{z}O_{w}, dans laquelle A est un ou plusieurs éléments du Groupe IIIa du Tableau Périodique Japonais, B est un ou plusieurs éléments du Groupe IIa du Tableau Périodique Japonais, et 0 < x < 1, y = 2-4, z = 1-4 et w = 4-10.
